# DEMANDE DE BREVET EUROPEEN

(11) **EP 0 798 772 A1**
(43) Date de publication de la demande: **01.10.1997**
(21) Numéro de dépôt: 97400658.7
(22) Date de dépôt: 24.03.1997
(51) Int. Cl.: H01L 21/48, H01L 21/288, C25D 5/02

(54) **Procédé de réalisation d'un dépôt sur un support amovible, et dépôt réalisé sur un support**

(30) Priorité: 26.03.1996 FR 9603727
(71) Demandeur: COMMISSARIAT A L'ENERGIE ATOMIQUE, 75015 Paris Cédex 15 (FR)
(72) Inventeur: Caillat, Patrice, 38130 Echirolles (FR)
(74) Mandataire: Dubois-Chabert, Guy

(57) **Abrégé**

L'invention concerne un procédé de réalisation d'un dépôt électrochimique (8-1,..., 8-4), à l'aide d'un substrat (2) comportant des plots (4-1,..., 4-5) de connexion, ces plots étant utilisés comme électrodes, le dépôt étant réalisé à la surface d'un support (6), amovible et apte à être ultérieurement séparé par rapport au substrat, sur des zones de ladite surface en contact électrique avec les plots du substrat.

## Description

### Domaine technique

L'invention concerne les techniques de formation d'un dépôt sur un substrat.

Des dépôts peuvent être obtenus par voie électrochimique. Un cas particulier est le dépôt électrolytique. Cette technique est utilisée en métallurgie pour recouvrir certaines pièces. Elle est également utilisée en micro-électronique, par exemple pour déposer des éléments conducteurs sur des électrodes d'une puce en cours de fabrication.

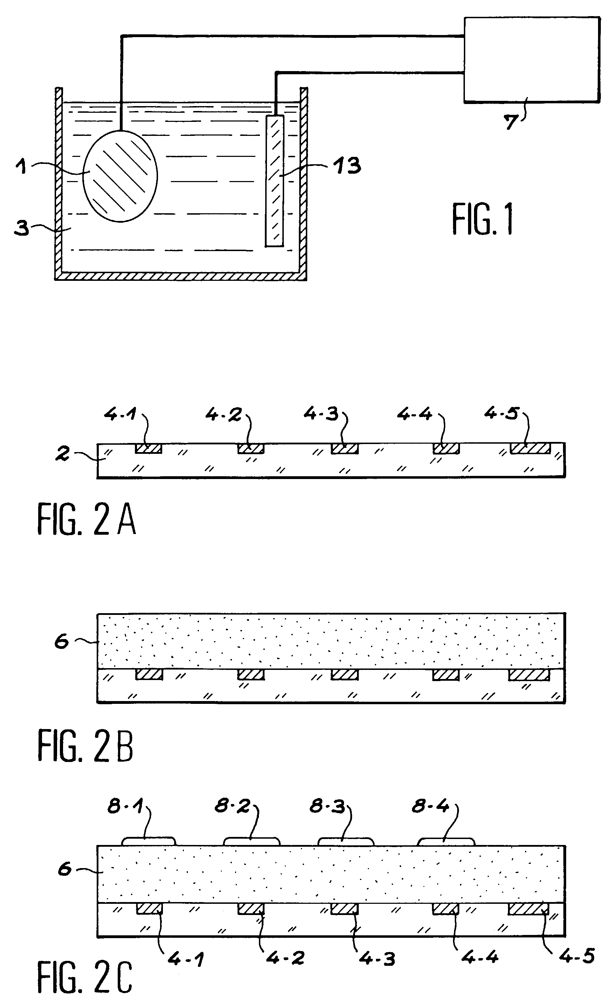

La technique du dépôt électrolytique peut être rappelée brièvement, en liaison avec la figure 1. Une pièce, ou électrode, 1, sur laquelle se fait le dépôt désiré est plongée dans un électrolyte 3. Une contre-électrode 13 est également plongée dans cet électrolyte. La pièce, ou électrode, et la contre-électrode sont reliées à un générateur de tension 7. L'électrolyte comporte des ions en solution, qui vont se déposer sur la pièce 1, en fonction de leur charge et de la tension appliquée par le générateur 7. Le dépôt peut être réalisé sur une pièce complète (dans ce cas on réalise une métallurgie de surface) ou sur une partie de pièce, comme c'est le cas en micro-électronique.

Cette technique de base est de plus en plus utilisée. Elle était initialement réservée aux dépôts de métaux purs, comme le cuivre ou le nickel. Mais elle se généralise maintenant aux dépôts électrochimiques faisant appel, non plus à un déplacement d'ions simples, mais à des déplacements de composés complexes, obtenus notamment à partir de substances organiques. On utilise par exemple l'oxydoréduction, qui s'opère sur la pièce, pour copolymériser des polymères entre eux.

La présente invention concerne donc d'abord le dépôt électrolytique de substances telles que des ions, ou des composés complexes.

Mais elle concerne également toutes les techniques de dépôt sur un substrat, plongé dans une atmosphère contenant des ions à déposer.

### Etat de la technique

Comme il a été dit ci-dessus, l'électrode, ou pièce à traiter, peut être un composant micro-électronique, comme une puce.

Le document de J.FRANKA intitulé "Solder Bump Technology : present and future", paru dans Semiconductor Fabtech, pages 289-295 décrit un procédé pour déposer, à la surface d'une puce, un matériau conducteur (étain-plomb). Pour cela, on rend d'abord conductrice la surface de la plaquette sur laquelle le dépôt doit être réalisé, en y pulvérisant une fine couche métallique. Une étape de lithographie est ensuite réalisée, par dépôt d'une résine et insolation-développement pour ouvrir la résine aux endroits où on désire un dépôt. La tranche est ensuite connectée à un générateur de tension, par l'intermédiaire de la fine couche conductrice, puis est trempée dans un électrolyte. Un dépôt électrolytique est donc réalisé, en particulier dans les zones où la résine est ouverte. Cette dernière est ensuite éliminée, puis la couche conductrice est gravée sélectivement en ne laissant subsister que la couche localisée obtenue lors de la croissante électrolytique. Cette technique peut, d'une manière générale, s'appliquer au cas où un faible nombre de plots sont à réaliser, et ou un matériau unique est à déposer sur ces plots.

Le document de R. Kakerow et al., intitulé "A monolithic sensor array of individually addressable microelectrodes", paru dans "Sensor and Actuator" A, 43 (1994), pages 296-301, décrit le traitement simultané d'un grand nombre de puces sur une même tranche de semi-conducteur, pour déposer sélectivement un composé chimique sur des électrodes déterminées de chaque puce.

Le document intitulé "Array of individually addressable microelectrode", de G. C. Fiaccabrino et al., paru dans "Sensor and Actuator" B, 18-19 (1994), pages 675-677 décrit une technique multiplexant les électrodes d'une puce pour réaliser, à partir de cette puce, un capteur à matrice d'électrodes apte à effectuer des mesures en milieu chimique, ou biochimique. La demande de brevet français n°95 13659 du 17 Novembre 1995 décrit par ailleurs une technique qui permet, lorsque plusieurs matériaux différents sont à déposer sélectivement sur des électrodes choisies, d'éviter d'avoir à refaire à chaque fois une nouvelle étape de lithographie, ce qui peut être très coûteux. Cette technique utilise également des moyens d'adressage et/ou de multiplexage.

Les procédés décrits dans l'art antérieur se heurtent tous à une limitation de base. Une fois le, ou les, dépôt(s) électrochimique(s) réalisé(s) à la surface d'un substrat, ce dernier ne peut plus être utilisé. En particulier, dans le cas où le substrat comporte des éléments actifs tels que par exemple des moyens d'adressage et de multiplexage intégrés, utilisés au cours du dépôt électrochimique, ces éléments ne peuvent ensuite plus être réutilisés pour effectuer de nouveaux dépôts. De plus, si, par exemple, différents dépôts, correspondant à des dispositifs indépendants, ont été réalisés sur ce même substrat, ce dernier doit être découpé pour pouvoir utiliser les dispositifs indépendamment les uns des autres. Or, lorsqu'on réalise des dépôts localisés en surface, un ensemble complet comportant le substrat, et toute la technologie utilisée (tels que moyens d'adressage, ou de multiplexage), doit être acheté. Par exemple, dans le cas de puces à électrodes multiplexées, le substrat intègre 10 à 12 niveaux de technologie micro-électronique, nécessaires à la réalisation des fonctions logiques. L'opération de dépôt électrolytique vient rajouter un à deux niveaux de technologie, et le produit final intègre donc environ une douzaine de niveaux technologiques, dont seuls les deux derniers présentent en général un intérêt pour l'utilisation ultérieure.

### Exposé de l'invention

L'invention résout ces problèmes en proposant un procédé de réalisation d'un dépôt électrochimique, à l'aide d'un substrat comportant des plots, ou zones, de connexion, ces plots étant utilisés comme électrode, le dépôt étant réalisé à la surface d'un support, amovible et apte à être ultérieurement séparé par rapport au substrat, sur des zones de ladite surface en contact électrique avec les plots du substrat.

Ainsi, on peut séparer le support et la partie déposée en surface du support, du substrat ayant permis ce dépôt. Ceci permet au substrat d'être ensuite réutilisé, pour effectuer d'autres supports de dépôt. On entend, par réalisation d'un dépôt électrochimique, aussi bien le dépôt d'un même composé sur des zones indépendantes que le dépôt de plusieurs composés sur lesdites zones. De plus, on entend par formation du support sur le substrat, aussi bien la réalisation de ce support par construction sur le substrat que le report direct d'un support, comportant déjà des liaisons électriques, sur le substrat.

Après avoir réalisé un dépôt et séparé le support, ce dernier conserve à sa surface les matériaux déposés et l'ensemble peut être découpé pour isoler des dépôts individuels ou des groupes de dépôts correspondants aux produits à réaliser, tels que par exemple des capteurs.

Le coût du produit final (le dépôt réalisé) se trouve réduit, du fait de la possibilité de réutiliser plusieurs fois la partie coûteuse du dispositif. En particulier, il est possible de réutiliser une structure d'adressage complexe des électrodes, intégrée dans le substrat, puisque ce dernier devient un outil, et n'est plus une partie sacrificielle du dispositif. Mais, même lorsque le substrat n'incorpore pas d'éléments actifs intégrés, le dépôt final obtenu peut être compétitif en terme de coût, par rapport aux dépôts réalisés selon des procédés classiques, puisqu'on récupère le substrat à chaque fois.

Ce procédé peut comporter, au préalable :
- soit la formation du support sur le substrat, ce support étant apte à être séparé ultérieurement du substrat.
- soit :
   * la formation d'une couche intermédiaire sur le substrat,
   * la réalisation de connexions électriques entre les plots du substrat et la surface supérieure de la couche intermédiaire,
   * la formation du support sur la couche intermédiaire, ce support étant apte à être séparé ultérieurement de la couche intermédiaire, les connexions électriques de la couche intermédiaire permettant une mise en contact électrique des plots du substrat avec les zones de la surface sur lesquelles le dépôt est réaliser.

Dans ce dernier cas, la couche intermédiaire peut être une couche sacrificielle attaquable, thermiquement ou chimiquement, sélectivement par rapport au substrat et au support.

Ainsi, la couche intermédiaire peut être une couche de colle époxy ou une couche de polyimide : elle est alors attaquable chimiquement.

Par ailleurs, cette couche intermédiaire peut être une couche de colle thermoplastique ou une couche de composés à base de paraffine : dans ce cas, elle est attaquable thermiquement.

La couche intermédiaire peut également être un film conducteur anisotrope en z. Dans ce cas, le film lui-même assure la liaison électrique entre le substrat et le support. Dans les autres cas, des connexions électriques à travers la couche intermédiaire peuvent être obtenues par gravure de cette couche intermédiaire, au-dessus des plots du substrat, puis dépôt, ou croissance, de matériaux conducteurs dans les zones gravées ainsi obtenues.

Dans tous les cas, le support peut être un film conducteur anisotrope, ou un élastomère conducteur anisotrope. Le contact électrique entre la surface du support et les plots du substrat est alors assuré par le support lui-même, via éventuellement les connexions électriques de la couche intermédiaire.

Selon une variante, le support peut être en un matériau polymère, tel que polyimide, ou en une colle époxy, ou ce peut être un matériau à base d'un composé minéral, le procédé comportant alors en outre une étape préalable de réalisation de connexions électriques entre les plots du substrat ou les connexions électriques de la couche intermédiaire et la surface du support sur laquelle le dépôt doit être réalisé, ou entre le film conducteur anisotrope en z constitutif de la couche intermédiaire et la surface du support sur laquelle le dépôt doit être réalisé. Là encore, l'étape de réalisation des connexions électriques peut comporter une gravure du support, au-dessus des plots du substrat, et une étape de dépôt ou de croissance de matériaux conducteurs dans les zones gravées.

Selon un mode particulièrement avantageux, au moins certaines des zones gravées comportent chacune une pluralité de trous d'axes sensiblement parallèles entre eux. Ce mode de réalisation permet d'améliorer le décollement du support, après réalisation du dépôt. En effet, lorsque la densité d'électrode (ou de zones de dépôt) devient importante, la partie isolante du "support" devient faible par rapport à la partie "connexion électrique". Lors d'une étape ultérieure de décollement ou de séparation du support par rapport au substrat, un déchirement est alors à craindre. Une solution à ce problème consiste à obtenir, en surface du support, de grandes zones recouvertes par le matériau choisi pour le dépôt, tout en conservant une grande surface de matériau support à l'intérieur du support. Ce résultat est obtenu en donnant à la zone gravée, au-dessus d'au moins certains plots, la forme d'une pluralité de trous d'axes sensiblement parallèles entre eux.

Un autre mode de réalisation particulièrement avantageux consiste à réaliser préalablement des microbilles de connexion sur les plots de connexion du substrat (ou de la couche intermédiaire), et à effectuer ensuite le dépôt du matériau constitutif du support, autour des microbilles et au-dessus du substrat, ou de la couche intermédiaire.

L'intérêt de ce procédé réside alors dans l'évasement obtenu, du fait de la présence des microbilles, au-dessus des plots électriques. En effet, le support déposé ensuite enrobe les microbilles sur une grande surface. Un décollement mécanique aisé est donc obtenu puisque, du point de vue métallurgique la bille n'est en contact, avec les plots, que sur une faible surface.

Dans le cas où les zones du support, sur lesquelles le dépôt doit être réalisé, ne sont pas, ou peu, compatibles avec le matériau de dépôt, il est possible de réaliser un dépôt préalable, sur ces zones, d'une couche de matériau compatible avec le dépôt électrochimique final, comme par exemple une couche d'or pour le dépôt de molécules actives.

Dans tous les cas, le dépôt électrochimique réalisé peut être un dépôt de molécules actives, choisies dans le groupe de molécules biochimiques ou biologiques.

Les plots du substrat peuvent être directement reliés à des moyens d'alimentation (dans ce cas, on a un substrat "passif"). Les plots du substrat peuvent, selon une variante, être reliés à des moyens d'alimentation par des moyens d'adressage et/ou de multiplexage (on a dans ce cas un substrat "actif").

L'invention a également pour objet un dépôt sur un support, ce dépôt étant susceptible d'avoir été réalisé de manière électrochimique sur une première face de ce support, ce dernier ayant une seconde face, en contact électrique avec la première.

### Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :
- la figure 1, déjà décrite, illustre schématiquement un dispositif pour réaliser un dépôt électrochimique,
- les figures 2A à 2D représentent un premier mode de réalisation de l'invention,
- les figures 3A à 3F représentent une variante du premier mode de réalisation de l'invention,
- les figures 4A à 4D représentent un second mode de réalisation de l'invention,
- les figures 5A à 5G, 6A à 6E représentent deux variantes du second mode de réalisation de l'invention,
- les figures 7A à 7F représentent une troisième variante du second mode de réalisation de l'invention,
- les figures 8A à 8E sont des exemples de dépôt sur support, selon l'invention,
- la figure 9 est un exemple de substrat utilisable dans un procédé selon l'invention.

### Exposé détaillé de modes de réalisation de l'invention

Un premier mode de réalisation de l'invention va être décrit en liaison avec les figures 2A à 2D.

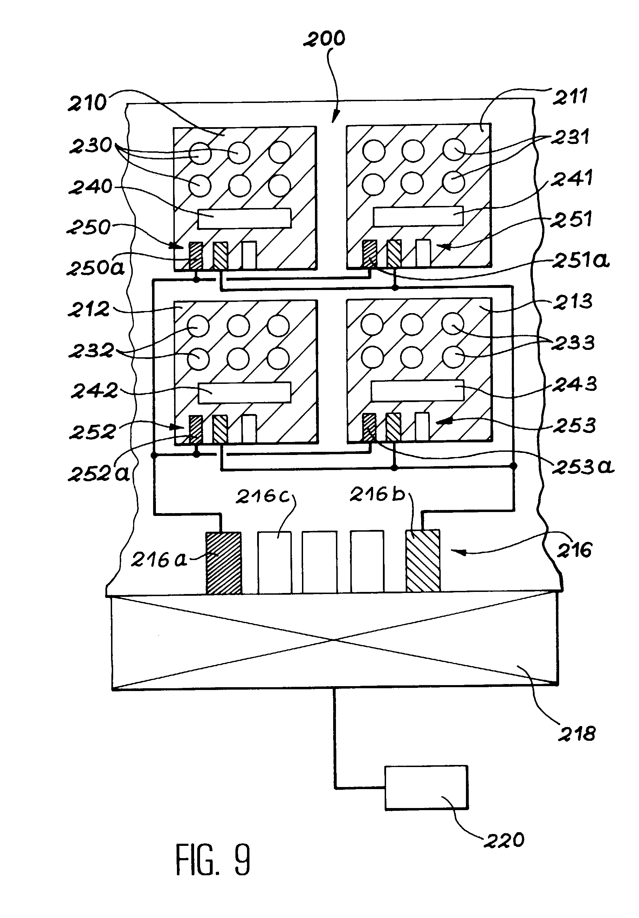

Un substrat 2 est tout d'abord sélectionné ou préparé (figure 2A). Ce substrat comporte des plots ou zones conductrices 4-1, 4-2, 4-3, 4-4, 4-5. Les plots 4-i sont représentés de manière schématique, mais ils peuvent avoir toute forme, répartition ou disposition possible. En particulier, ces plots, ou zones conductrices, peuvent être des électrodes de puces, réalisées sur un substrat de base, selon les procédés usuels de la micro-électronique. Un tel exemple de composant est donné à la fin de la présente description, en liaison avec la figure 9.

Sur le substrat 2, une nappe conductrice en Z, 6 est déposée (figure 2B). Une telle nappe peut être un film conducteur anisotrope du commerce ou un élastomère conducteur. L'épaisseur de cette nappe sera choisie en fonction de la rigidité souhaitée, elle-même déterminée par l'usage ultérieur.

Les plots 4-i sont connectés, par l'intermédiaire d'éléments conducteurs non représentés sur les figures, et de plots de connexion vers une ou plusieurs source(s) de tension. L'ensemble substrat 2-nappe conductrice 6 est alors plongé dans un milieu comportant des ions destinés à être déposés en surface de la nappe 6. Ce milieu peut être un milieu fluide, par exemple un bain chimique d'électolyte dans le cas d'un dépôt électrolytique (figure 1) ou, encore par exemple, un gaz ou une vapeur ou un plasma contenant des ions à déposer. Par adressage sélectif des plots, des dépôts 8-1, 8-2, 8-3, 8-4 sont donc effectués sur la nappe 6 (figure 2C). Les dépôts peuvent être réalisés simultanément, si tous les plots 4-i sont adressés simultanément par la source de tension. Ils peuvent également être réalisés successivement : on adresse par exemple d'abord les plots 4-1 et 4-2, et les dépôts 8-1, 8-2 sont donc d'abord réalisés sur la nappe 6 dans les zones en regard des plots 4-1 et 4-2. Puis, on coupe l'alimentation sur ces premiers plots, et les plots 4-3, 4-4 sont adressés. Les dépôts 8-3, 8-4 sont ainsi réalisés en regard des plots 4-3 et 4-4. Ainsi, il est possible de réaliser des dépôts d'une certaine nature, au-dessus de certains plots, en adressant d'abord ces plots. Puis, en modifiant l'environnement (par exemple en trempant l'ensemble dans un autre électrolyte), un autre type de dépôt peut être réalisé, au-dessus d'autres plots.

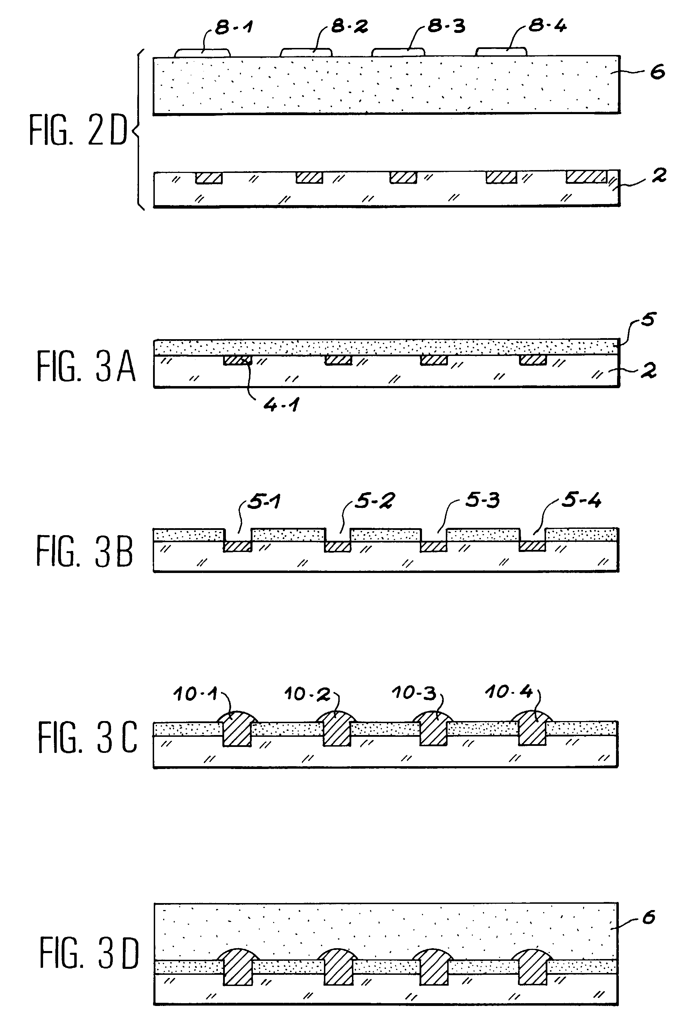

A la suite du dépôt, la nappe 6 est séparée du substrat 2 (figure 2D). Dans le cas d'un film polymère anisotrope, ou d'un élastomère conducteur en z, la séparation est obtenue par choc thermique en jouant sur la différence de dilatation thermique entre le support et le substrat ou mécaniquement (par arrachement) ou encore sous insolation U.V. si la nappe comporte antérieurement à son dépôt une face recouverte d'une colle sensible aux U.V.

Le résultat obtenu est un film, ou nappe, 6 à la surface duquel des dépôts spécifiques sont réalisés, sur des zones choisies. Le substrat 2 et ses plots 4-i étant séparé, il est possible de le réutiliser pour un autre dépôt, sur une autre nappe. Ceci est particulièrement avantageux dans le cas où ce substrat intègre, comme illustré sur la figure 9, un certain nombre d'éléments complexes, tels que des circuits d'adressage et de multiplexage.

De son côté, la nappe 6 peut être par exemple découpée, afin d'obtenir des dépôts individuels ou groupés utilisables en tant que capteurs, par exemple des capteurs biologiques comme décrits dans le document WO 94/22889 : de tels capteurs sont utilisés dans le domaine de la caractérisation biologique, les dépôts 8-i réalisés étant par exemple alors des dépôts de molécules actives, par exemple choisies dans le groupe des molécules biochimiques ou biologiques. Ces molécules actives sont des réactifs appelés à réagir sélectivement lors d'une analyse biochimique ou biologique.

Une variante du procédé selon le premier mode de réalisation de l'invention va être décrite, en liaison avec la figure 3A à 3F. L'élément de départ est un substrat 2 (identique à celui déjà décrit ci-dessus) avec ses plots 4-i. Sur ce substrat, est déposée une couche 5 sacrificielle (figure 3A) chimiquement ou thermiquement attaquable par rapport aux support et substrat. A titre d'exemple de couche attaquable thermiquement, on peut citer des colles thermoplastiques, les composés à base de paraffine. Comme exemple de couche attaquable chimiquement par rapport au support en polyimide, on peut citer une colle époxy ou silicone. Cette couche est ensuite gravée (figure 3B) de façon à dégager des ouvertures 5-1, 5-2, 5-3, 5-4 au-dessus des plots 4-i. La gravure peut être par exemple du type gravure plasma réactif en présence de gaz fluoré, et être effectuée à travers un masque de résine réalisé par exemple par photolithographie.

Il est ensuite procédé (figure 3C) à une étape de dépôt, ou de croissance, de plots métalliques 10-1, ..., 10-4 dans les ouvertures 5-i. Le dépôt peut être réalisé par croissance électrolytique, le métal étant par exemple du chrome, du nickel ou du titane. Les plots 10-i obtenus peuvent être débordants, par rapport à la surface supérieure de la couche 5, ou affleurer cette surface.

Une nappe conductrice 6 est ensuite déposée (figure 3D). Les caractéristiques de cette nappe sont les mêmes que celles qui ont déjà été données ci-dessus, dans le cadre de la description du premier mode de réalisation.

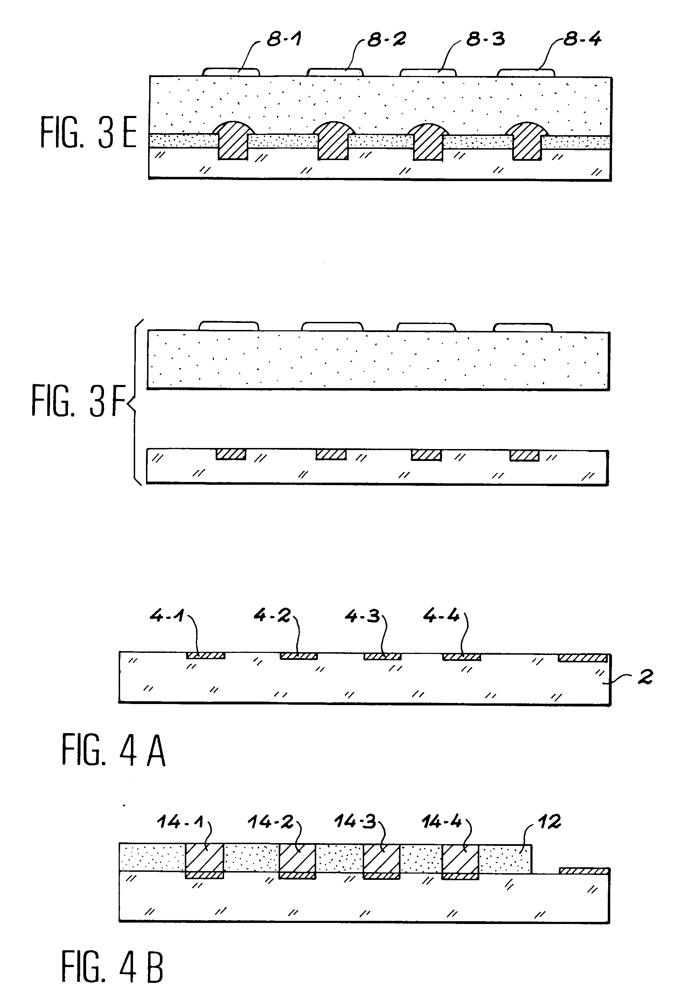

Les plots 10-i permettent d'établir un contact entre les plots 4-i du substrat 2 et la nappe 6. Il est donc possible de réaliser, comme déjà décrit ci-dessus, des dépôts 8-1, ..., 8-4 (figure 3E) de la manière décrite ci-dessus en liaison avec la figure 2C, dans le même type d'environnement, par exemple sélectivement pour obtenir des dépôts de différente nature.

On procède ensuite à la séparation de la nappe 6 et du substrat 2, par exemple par chauffage ou gravure chimique de la couche sacrificielle et avantageusement du métal déposé pour réaliser les plots 10-i. Dans le cas d'une séparation par chauffage, la température utilisée doit être inférieure à la température de dégradation du support. Le résultat obtenu, illustré sur la figure 3F, est équivalent à celui obtenu selon le premier mode de réalisation du procédé (figure 2D), avec les mêmes utilisations possibles et les mêmes avantages.

Selon un autre mode de réalisation de l'invention, le support peut être un support en une matière isolante, telle qu'un matériau polymère ou polyimide ou en une colle époxy. Ce peut être également un support en un matériau minéral, par exemple SOG (ou verre liquide déposé par des moyens micro-électronique). Du fait du caractère isolant du support, des moyens spécifiques de connexion électrique, depuis les plots vers la surface dudit support, sont prévus. Le point de départ du procédé (figure 4A) est toujours un substrat 2 muni de ses plots de connexion 4-i. Sur ce substrat est déposé un support 12 en une matière isolante. Dans le cas d'un polymère, celui-ci peut être déposé sous forme liquide par exemple à la tournette puis recuit ou rapporté sous forme de film sur la structure. Comme illustré sur la figure 4B, des ouvertures sont ensuite pratiquées dans le support, au-dessus des plots de connexion 4-i. Ces ouvertures peuvent être réalisées par gravure, par exemple du type gravure plasma réactif en présence de gaz fluoré, à travers un masque réalisé par exemple par photolithographie. Dans les ouvertures obtenues, des plots métalliques 14-1, 14-2, 14-3, 14-4 sont réalisés, par exemple par croissance électrolytique de métal (par exemple Cr, Ni, Ti, SnPb, In), avec ou sans débordement. Ces plots permettent d'établir un contact électrique entre les plots 4-i du substrat 2 et la surface supérieure du support.

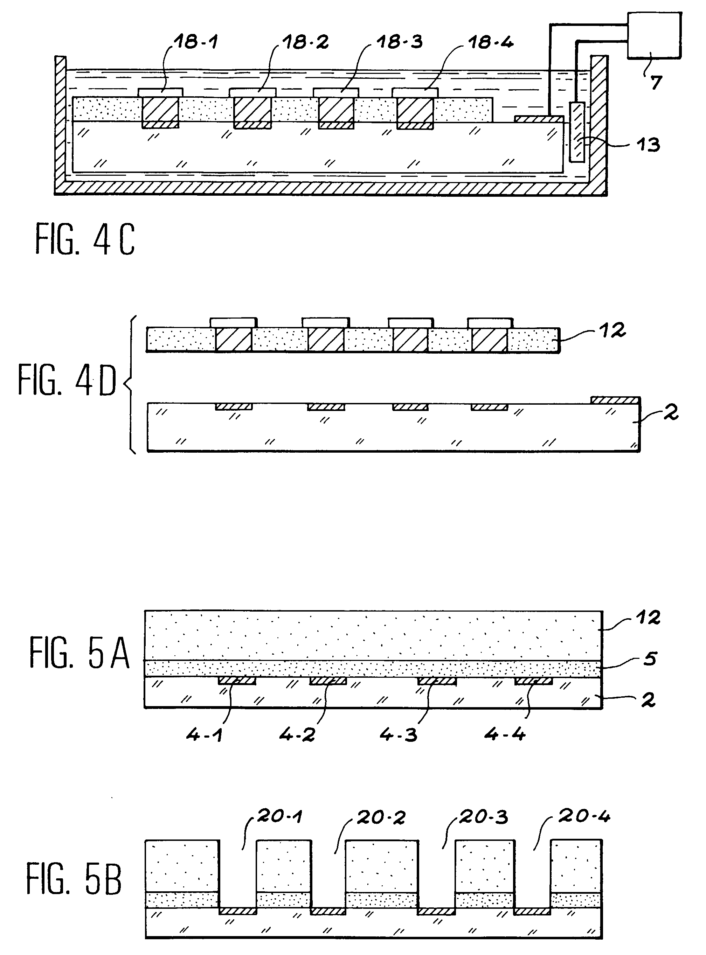

Les plots 4-i peuvent ensuite être reliés à une source de tension, et l'ensemble nappe 12-substrat 2 est plongé dans un milieu, par exemple un milieu fluide, contenant des ions destinés à être déposés en surface du support sur les zones du support 12 définies par les plots 14-i. Dans le cas d'un dépôt électrolytique, le substrat 2 est relié par ses bornes à un générateur 7 (figure 4C) et est plongé dans un bain électrolytique 3, dans lequel est également plongée une contre-électrode 13. On obtient ainsi des dépôts 18-1, 18-2, 18-3, 18-4 en surface du support 12. Là encore, les dépôts peuvent être réalisés par adressage simultané ou séquentiel des plots 4-i, et par trempage de l'ensemble support-substrat dans des bains électrolytiques pouvant contenir des espèces différentes.

On procède ensuite (figure 4D) à une étape de séparation, du support 12 et du substrat 2. Le support 12 étant en un matériau polymère avec une liaison métallique, le décollement peut être réalisé par choc thermique ou mécaniquement.

Là encore, l'intérêt majeur du procédé réside dans la possibilité de pouvoir réutiliser le substrat 2 pour réaliser d'autres dépôts, sur d'autres supports. Le support 12 obtenu, avec ses dépôts 18-i, peut ensuite être par exemple découpé pour réaliser des capteurs.

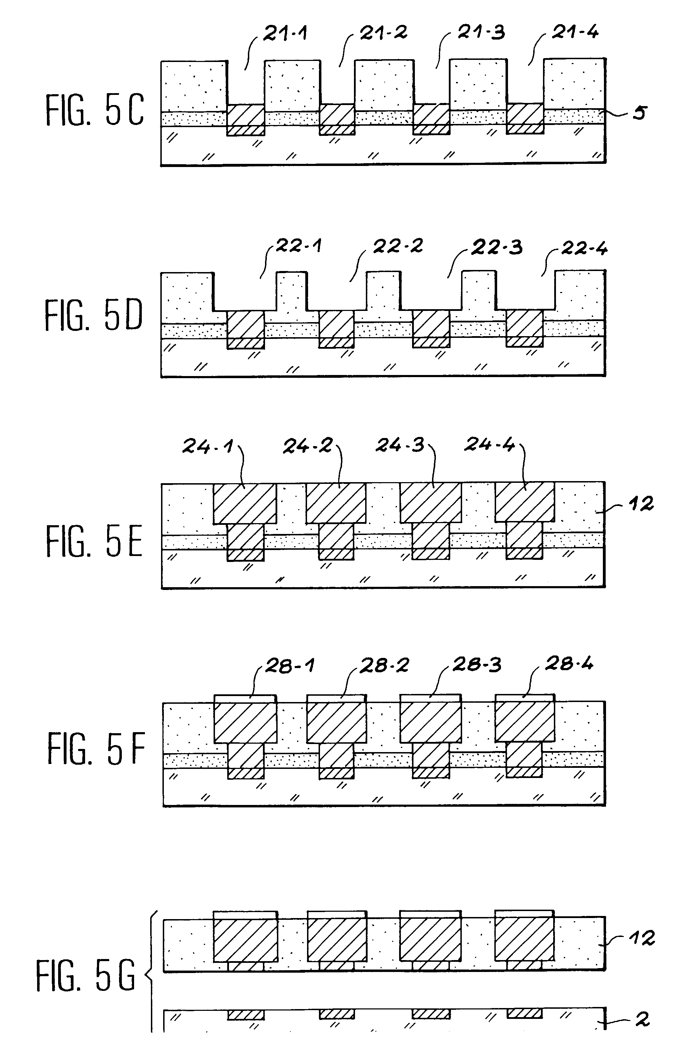

Comme illustré sur les figures 5A à 5G, le procédé mettant en oeuvre un support isolant peut également mettre en oeuvre une couche intermédiaire sacrificielle (couche de colle thermoplastique, ou couche de polymère attaquable chimiquement sélectivement, par exemple une couche de colle époxy pour un support en polyimide).

Par photolithographie et gravure, des fenêtres 20-1, 20-2, 20-3, 20-4 sont ouvertes dans les deux couches 5 et 12 (figure 5B). Dans ces fenêtres sont réalisés des dépôts métalliques, par exemple par croissance électrolytique de métal (Ni, Cr, Ti, SnPb, In) pour réaliser un contact électrique à travers la couche intermédiaire 5. Le dépôt peut être réalisé sur une épaisseur supérieure à celle de la couche 5.

Eventuellement (figure 5D), une deuxième étape de lithographie et de gravure permet d'ouvrir, dans le support 12, des fenêtres 22-1, 22-2, 22-3, 22-4 plus larges que celles ouvertes dans la couche intermédiaire 5. L'utilisation de fenêtres de dimensions différentes permet une séparation plus aisée du support. En effet, les zones de faible largeur cassent avant les zones de plus fortes largeurs. Puis, des dépôts métalliques épais 24-1, 24-2, 24-3, 24-4 sont réalisés dans ces fenêtres 22-i (figure 5E), par exemple par croissance électrolytique de métal, au-dessus des plots 4-i du substrat 2 et des connexions 21-i réalisées à travers la couche 5. Ainsi, une connexion électrique continue est établie entre chacun des plots du substrat et la surface supérieure de la nappe, ou support, 12.

Il est ensuite procédé à des dépôts 28-1, 28-2, 28-3, 28-4 sur les connexions électriques à la surface supérieure du support 12 (figure 5F) : l'ensemble est plongé dans une atmosphère ou dans un fluide contenant des ions à déposer, et les plots 4-i sont reliés à un générateur de tension. Dans le cas d'un dépôt électrolytique, un dispositif similaire à celui décrit ci-dessus en liaison avec la figure 4C est mis en oeuvre. On réalise ainsi des dépôts de manière simultanée ou séquentielle.

L'étape finale est une étape de séparation du support 12 et du substrat 2 (figure 5G). Du fait de la présence d'une couche intermédiaire 5 à travers laquelle des plots de connexion électrique sont formés, les mêmes techniques que celles décrites ci-dessus en liaison avec la figure 3F peuvent être mises en oeuvre pour effectuer cette séparation. Comme représenté, lorsque les plots de connexion de la couche intermédiaire ne sont pas attaqués lors de la séparation, ils peuvent rester sur les liaisons électriques du support.

Là encore, le substrat 2 peut être réutilisé pour d'autres étapes de dépôt sur d'autres supports.

Selon un autre variante du second mode de réalisation (figures 6A-6E) le support sur lequel le dépôt est réalisé fait appel à la technologie des microbilles. Le procédé qui va être décrit fait intervenir en outre une couche intermédiaire 5, par exemple une couche sacrificielle, une couche de colle thermoplastique ou d'un composé à base de paraffine ou une couche de polymère sélectivement attaquable par rapport au support 32. Cependant, une autre variante peut être réalisée, qui ne met pas en oeuvre cette couche intermédiaire.

Sur le substrat 2 et sur la couche 5, à travers laquelle des connexions 10-i ont été réalisées, des microbilles 30-1, 30-2, 30-3, 30-4 sont déposées (figure 6A). Une technique pour obtenir ces microbilles est décrite par exemple dans l'article de J. Franka déjà cité ci-dessus, et fait intervenir un procédé par électrolyse et refonte.

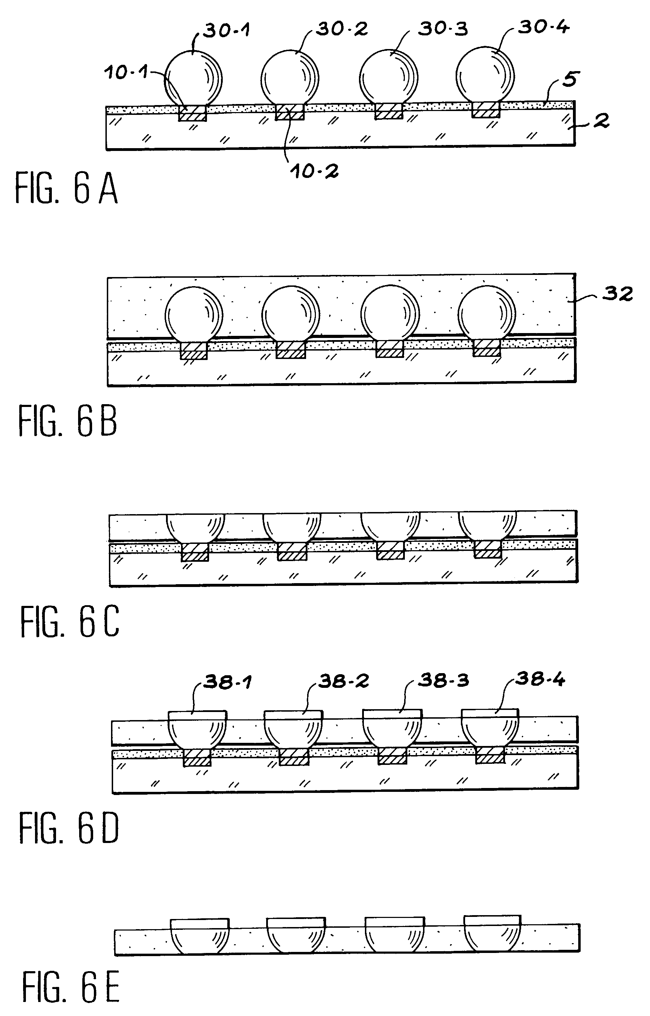

Une couche 32 est formée au-dessus de la couche intermédiaire 5. Cette couche 32 peut être une couche de colle époxy, ou une couche de polyimide. L'épaisseur de cette couche peut être telle que sa partie supérieure recouvre la partie supérieure des billes 30-i (figure 6B). Dans ce cas, afin de faire apparaître un contact électrique en surface du support sur lequel le dépôt est à réaliser, une étape supplémentaire, par exemple de rodage, permet de ramener l'épaisseur de l'ensemble à une valeur inférieure (figure 6C). Sur le composé obtenu, il est ensuite possible de réaliser des dépôts 38-i (i=1-4), selon les techniques déjà mentionnées ci-dessus, par exemple par dépôt électrochimique (figure 6D). L'étape suivant (figure 6E) est une étape de séparation, par exemple par chauffage, ou par gravure de la couche 5 intermédiaire. Il est également possible de réaliser un décollement purement mécanique dans le cas où le support est directement formé sur le substrat.

Quel que soit le mode de séparation choisi, l'intérêt de réaliser un support avec des microbilles est le suivant. Chaque microbille n'est en contact que par une faible surface avec les plots de contact électrique 5-i du substrat 2, ou 10-i de la couche 5. Le reste de la surface des microbilles est enrobé par la couche 32 de matériau isolant. L'ensemble peut être arraché plus facilement, lors de l'étape de séparation du support et du substrat.

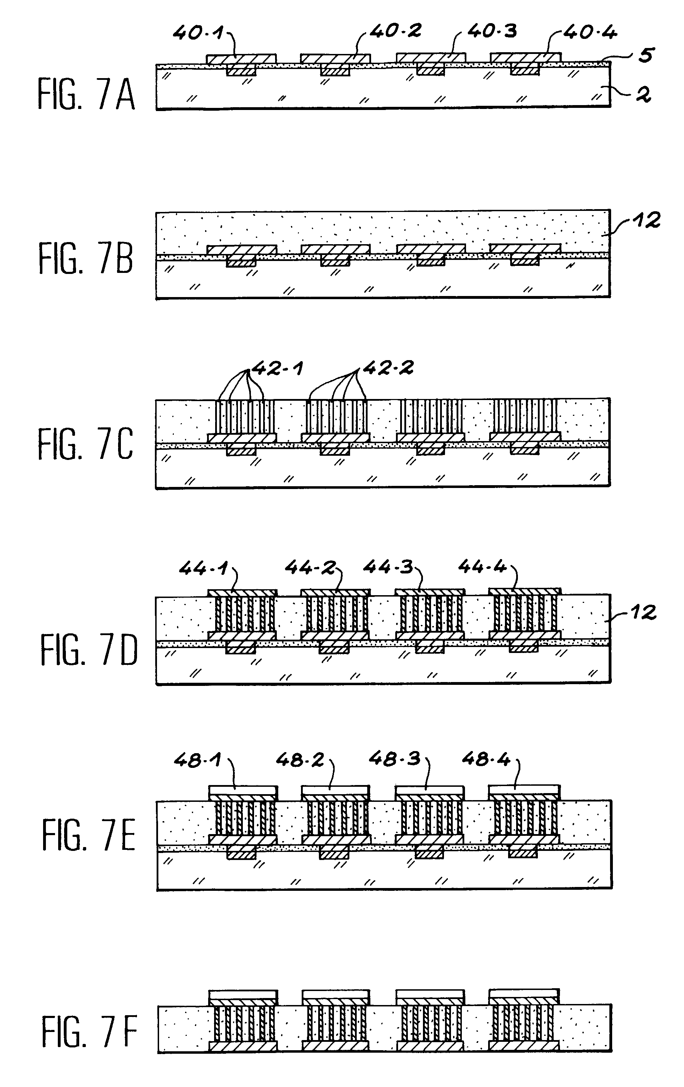

Ce problème d'arrachement, ou d'amélioration du décollement du support par rapport au substrat peut être également résolu par la mise en oeuvre du procédé suivant, qui va être décrit en liaison avec les figures 7A à 7F.

Un substrat 2, avec ses plots 4-i, est éventuellement recouvert d'une couche sacrificielle 5 qui est gravée, et à travers laquelle des connexions électriques 10-i sont établies. Eventuellement, un dépôt métallique un peu plus large 40-i (i=1-4) peut être réalisé au-dessus de chacun des plots 10-i. Une couche 12 de matériau isolant (figure 7B) est ensuite déposée sur l'ensemble.

Puis, une étape de gravure est réalisée dans la couche 12. Mais, cette fois, le masque de gravure présente une forme permettant de réaliser, au-dessus de chaque plot, une pluralité de trous 42-i (i=1-4), d'axes sensiblement parallèles entre eux (figure 7C).

Ces trous 42-i sont ensuite remplis, de manière électrochimique, par un métal de contact tel que de l'or ou du cuivre. Un dépôt métallique supplémentaire 44-i (i=1-4) peut être ensuite réalisé en surface du support 12 pour améliorer les conditions du dépôt électrochimique.

Ainsi, un composant est réalisé, sur lequel il est possible de réaliser un dépôt par voie électrochimique, par exemple par voie électrolytique, ainsi que déjà décrit ci-dessus dans le cadre des autres modes de réalisation. On obtient donc un composant recouvert d'un ensemble de dépôts 48-1, ..., 48-4 (figure 7E).

Le support 12, avec ses dépôts 48-i, est ensuite séparé du substrat 2, par exemple par chauffage ou par gravure de la couche sacrificielle. Du fait de la forme donnée aux zones de connexion (trous 42-i d'axes sensiblement parallèles entre eux) la surface de contact entre d'une part les plots 40-i et, d'autre part, les moyens de connexion à travers la couche 12, est réduite, ce qui facilite l'arrachement ou le décollage lors de l'étape finale. On évite ainsi les problèmes liés à un déchirement possible du support lors de cette étape grâce au grand volume de matériau support conservé.

Dans les différentes variantes de réalisation de l'invention, la croissance électrolytique de métal peut être formée par une ou plusieurs couches métalliques.

Par ailleurs, dans tous les cas, quel que soit le mode de réalisation envisagé, les zones de la surface du support sur lesquelles le dépôt doit être réalisé sont de préférence préalablement choisies de manière à être compatible avec ledit dépôt. Ainsi, dans le cas d'un dépôt électrolytique, et dans le cas où des liaisons électriques sont établies à travers un support isolant, la partie supérieure de ces liaisons, qui affleure la surface du support, est réalisée dans un matériau compatible avec le bain du dépôt électrolytique ; sinon, il est préférable de déposer au préalable, sur la zone sur laquelle le dépôt final doit être réalisé, une couche supplémentaire d'un matériau compatible, par exemple une couche d'or. Il en est de même dans le cas de l'utilisation d'une nappe anisotrope.

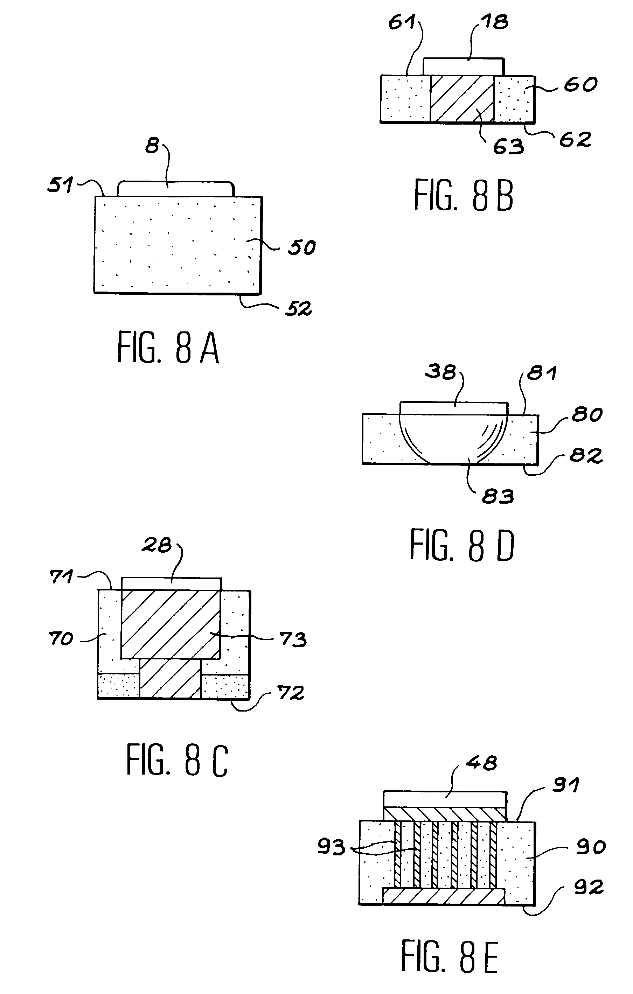

Ainsi qu'il a déjà été mentionné ci-dessus, il est possible, après réalisation d'un dépôt sur un support et séparation de ce support et du substrat, de découper le support pour obtenir des dépôts groupés individuels. Les figures 8A à 8E représentent schématiquement les structures individuelles obtenues, après une telle opération de dépôt, pour les différents modes de réalisation décrits ci-dessus. Dans tous les cas, on obtient un dépôt 8, 18, 28, 38, 48 sur une première face 51, 61, 71, 81, 91 d'un support 50, 60, 70, 80, 90.

Dans le cas de la figure 8A, le support 50 est un élément conducteur en z, par exemple une portion d'un film conducteur anisotrope ou d'un élastomère conducteur anisotrope.

Sur les autres figures 8B-8E, le support est un élément isolant, par exemple en un matériau polymère tel que polyimide ou une colle époxy, ou en un matériau minéral, et est traversé par un ou plusieurs élément(s) conducteur(s) 63, 73, 83, 93 qui relie(nt) électriquement la première face et une deuxième face 62, 72, 82, 92 du support.

Les différents moyens de connexion électrique correspondent aux différents éléments conducteurs décrits ci-dessus dans le cadre des différentes variantes des différents modes de réalisation d'un procédé selon l'invention.

Il est également possible de réaliser la découpe d'un support, sur lequel un dépôt a été réalisé conformément à l'invention, de façon à isoler non pas des dépôts individuels, mais des groupes de N dépôts (N>2) sur un même support, ce support étant de l'un des types décrits ci-dessus et, si il n'est pas conducteur anisotrope, incorporant des moyens de connexion électrique du type de ceux décrits ci-dessus.

Dans tous les cas, le substrat 2 sur lequel le support est formé peut être un substrat de composant électronique. Un tel composant peut être par exemple du type de celui illustré sur la figure 9.

La figure 9 montre un substrat de support 200 sur lequel on a réalisé une pluralité de puces électroniques 210, 211, 212, 213. Les puces sont réalisées selon les procédés usuels de micro-électronique.

Sur la figure, pour des raisons de lisibilité, seules quatre puces 210, 211, 212, 213 sont représentées, toutefois, la même tranche de substrat peut comporter un grand nombre de puces, par exemple de 20 à 2000.

Les puces de l'exemple illustré sont identiques les unes aux autres. Elles comportent chacune un nombre limité d'électrodes 230, 231, 232, 233, un circuit de multiplexage 240, 241, 242, 243 et un ensemble de bornes individuelles d'adressage 250, 251, 252, 253.

Le substrat 200 comporte aussi des bornes collectives d'adressage 216. Un connecteur 218 permet de relier les bornes 216 à une source de tension extérieure 220 apte à délivrer des signaux d'adressage. La source de tension extérieure peut être une interface spécialement adaptée à un micro-ordinateur, par exemple.

Après un test de validité des puces, celles-ci sont reliées entre elles dans des réseaux de puces. Les réseaux sont établis selon des plans de connexion dans lesquels des bornes d'adressage individuelles équivalentes de chaque puce sont respectivement reliées à des bornes collectives d'adressage correspondantes du support.

A titre d'illustration, les bornes individuelles 250a, 251a, 252a et 253a des puces 210, 211, 212, 213 sont toutes reliées entre elles et reliées à une borne collective 216a correspondante.

Le circuit de multiplexage interne 240, 241, 242, 243 de chaque puce permet d'adresser sélectivement une ou plusieurs électrodes sélectionnées, en fonction d'un signal d'adressage qui est appliqué par exemple sur l'une des bornes individuelles de la puce.

A titre d'exemple sur une première borne d'adressage 250a, 251a, 252a, 253a de chaque puce sont appliqués les signaux d'adressage des électrodes provenant de la borne collective 216a.

Des deuxièmes bornes individuelles de chaque puce, reliées par exemple à la borne collective 216b, sont destinées à l'alimentation électrique des puces.

Des troisièmes bornes individuelles de chaque puce sont reliées par exemple à la borne collective 216c par des liaisons non représentées sur la figure 2. Ces bornes sont destinées à fournir à chaque puce une tension de travail, c'est-à-dire une tension appropriée à la réaction chimique envisagée, cette tension étant distribuée sur la, ou les, électrode(s) adressée(s) par le circuit de multiplexage interne de chaque puce.

Enfin, des quatrièmes bornes individuelles (non représentées) des puces peuvent être reliées à une borne collective du substrat pour une remise à zéro logique des puces.

## Revendications

1. Procédé de réalisation d'un dépôt électrochimique, à l'aide d'un substrat comportant des plots de connexion, ces plots étant utilisés comme électrodes, le dépôt étant réalisé à la surface d'un support, amovible et apte à être ultérieurement séparé par rapport au substrat, sur des zones de ladite surface en contact électrique avec les plots du substrat.

2. Procédé selon la revendication 1, comportant au préalable la formation du support sur le substrat.

3. Procédé selon la revendication 1 comportant au préalable :
- la formation d'une couche intermédiaire sur le substrat,
- la réalisation de connexions électriques entre les plots du substrat et la surface supérieure de la couche intermédiaire,
- la formation du support sur la couche intermédiaire, ce support étant apte à être séparé, ultérieurement, de la couche intermédiaire, les connexions électriques de la couche intermédiaire permettant une mise en contact électrique des plots du substrat avec les zones de la surface sur lesquelles le dépôt est à réaliser.

4. Procédé selon l'une des revendications 2 ou 3, le support étant séparé du substrat ou de la couche intermédiaire, après réalisation du, ou des, dépôt(s) électrochimique(s).

5. Procédé selon la revendication 3, la couche intermédiaire étant une couche sacrificielle attaquable sélectivement, thermiquement ou chimiquement, par rapport au substrat et au support.

6. Procédé selon la revendication 3, la couche intermédiaire étant une couche de colle thermoplastique, ou une couche de composés à base de paraffine.

7. Procédé selon la revendication 3, la couche intermédiaire étant une couche de colle époxy, ou une couche de polyimide.

8. Procédé selon l'une des revendications 3, 6 ou 7, les connexions électriques entre les plots du substrat et la surface supérieure de la couche intermédiaire étant obtenues par gravure de la couche intermédiaire, au-dessus des plots du substrat, puis dépôt ou croissance de matériaux conducteurs dans les zones gravées ainsi obtenues dans la couche intermédiaire.

9. Procédé selon la revendication 8, le dépôt ou la croissance de matériaux conducteurs dans les zones gravées de la couche intermédiaire ayant lieu sur une épaisseur supérieure à celle de la couche intermédiaire.

10. Procédé selon la revendication 3, la couche intermédiaire étant un film conducteur anisotrope en z.

11. Procédé selon l'une des revendications précédentes, le support étant un film conducteur anisotrope ou un élastomère conducteur anisotrope.

12. Procédé selon l'une des revendications 1 à 10, le support étant en un matériau polymère ou un matériau à base d'un composé minéral, le procédé comportant en outre une étape préalable de réalisation de connexions électriques entre les plots du substrat, ou les connexions électriques de la couche intermédiaire, et la surface du support sur laquelle le dépôt doit être réalisé, ou entre le film conducteur anisotrope en z constitutif de la couche intermédiaire et la surface support sur laquelle le dépôt doit être réalisé.

13. Procédé selon la revendication 12, la réalisation des connexions électriques, entre les plots du substrat et la surface du support, comportant une gravure du support au-dessus des plots des substrats, et une étape de dépôt, ou de croissance, de matériaux conducteurs dans les zones gravées ainsi obtenues dans le support.

14. Procédé selon la revendication 13, au moins certaines des zones gravées comportant chacune une pluralité de trous d'axes sensiblement parallèles entre eux.

15. Procédé selon les revendications 8 et 13, une première gravure du support ayant lieu avant la gravure de la couche intermédiaire, et le dépôt ou la croissance de matériaux conducteurs dans les zones gravées de la couche intermédiaire ayant lieu avant le dépôt ou la croissance de matériaux conducteurs dans le support.

16. Procédé selon la revendication 15, le dépôt, ou la croissance, de matériaux conducteurs dans les zones gravées de la couche intermédiaire étant suivi d'une seconde étape de gravure du support.

17. Procédé selon l'une des revendications 1 à 9, comportant la formation de microbilles de connexion sur les plots de connexion du substrat ou de la couche intermédiaire, puis le dépôt du matériau constitutif du support, autour des microbilles et au-dessus du substrat ou de la couche intermédiaire.

18. Procédé selon la revendication 17, le dépôt du matériau constitutif du support étant tel que la surface de ce dépôt recouvre les microbilles, l'ensemble étant ensuite ramené à une épaisseur laissant apparaître une coupe des microbilles.

19. Procédé selon l'une des revendications précédentes, un dépôt d'un matériau compatible avec le dépôt électrochimique étant réalisé au moins sur les zones du support destinées à être recouvertes par le dépôt électrochimique.

20. Procédé selon l'une des revendications précédentes, les plots du substrat étant directement reliés à des moyens d'alimentation.

21. Procédé selon l'une des revendications 1 à 19, les plots du substrat étant reliés à des moyens d'alimentation par des moyens d'adressage et/ou de multiplexage.

22. Procédé selon l'une quelconque des revendications précédentes, le dépôt électrochimique réalisé étant un dépôt de molécules actives choisies dans le groupe de molécules biochimiques ou biologiques.

23. Procédé selon l'une des revendications 1 à 21, le dépôt électrochimique étant un dépôt électrolytique.

24. Procédé selon l'une des revendications 1 à 21, le dépôt électrochimique étant réalisé à partir d'une atmosphère gazeuse.

25. Ensemble de N dépôts (N≥2) sur un support, ces dépôts étant susceptibles d'avoir été réalisés de manière électrochimique sur une première face de ce support, ce dernier ayant une seconde face, en contact électrique avec la première, une partie des dépôts ayant une certaine nature ou constitution différente de celle d'une autre partie des dépôts.

26. Ensemble de N dépôts sur un support, selon la revendication 25, le support étant une portion au moins de film conducteur anisotrope, ou un élastomère conducteur anisotrope.

27. Ensemble de N dépôts sur un support, selon la revendication 26, le support étant en un matériau polymère ou en un matériau à base d'un composé minéral, au moins une connexion électrique étant réalisée entre la première et la deuxième faces.

28. Ensemble de N dépôts sur un support, selon la revendication 27, chaque connexion électrique étant une portion de microbille conductrice.

29. Ensemble de N dépôts sur un support, selon la revendication 27, chaque connexion électrique comportant une pluralité d'éléments conducteurs allongés et parallèles disposés sous le dépôt.
